# EUROPEAN PATENT APPLICATION

(11) **EP 4 827 259 A1**
(43) Date of publication of application: **21.10.2026**
(21) Application number: 24916513.5
(22) Date of filing: 18.10.2024
(51) Int. Cl.: H05K 9/00

(54) **COMPOSITE SHIELDING FILM, ELECTROMAGNETIC SHIELDING STRUCTURE, AND ELECTRONIC DEVICE**

(30) Priority: 09.01.2024 CN 202410033787
(71) Applicant: Huawei Technologies Co., Ltd., Shenzhen, Guangdong 518129 (CN)
(72) Inventor: CHEN, Liye, Shenzhen, Guangdong 518129 (CN); LI, Cheng, Shenzhen, Guangdong 518129 (CN); DI, Wei, Shenzhen, Guangdong 518129 (CN)
(74) Representative: Huawei European IPR
(86) International application number: PCT/CN2024/125902
(87) International publication number: WO 2025/148462

(57) **Abstract**

A composite shielding film, an electromagnetic shielding structure, and an electronic device are provided, and relate to the field of electronic technologies. The composite shielding film includes a first conductive layer, a second conductive layer, and a conductive structure. The first conductive layer and the second conductive layer are opposite to each other and spaced apart from each other, and an orthographic projection region of the second conductive layer on a reference plane parallel to the first conductive layer is located in an orthographic projection region of the first conductive layer on the reference plane. An electrical conductivity of the first conductive layer ranges from 2000 siemens per meter to 80000 siemens per meter. An electrical conductivity of the second conductive layer is greater than or equal to 1000 siemens per meter. For example, the electrical conductivity of the second conductive layer is greater than the electrical conductivity of the first conductive layer. The conductive structure is connected to the first conductive layer and the second conductive layer, and is configured to ground the first conductive layer and the second conductive layer. The composite shielding film can effectively shield an electromagnetic wave signal, and reduce leakage of the electromagnetic wave signal. This application is used to shield the electromagnetic wave signal.

## Description

This application claims priority to Chinese Patent Application No. 202410033787.5, filed on January 9, 2024 and entitled "COMPOSITE SHIELDING FILM, ELECTROMAGNETIC SHIELDING STRUCTURE, AND ELECTRONIC DEVICE", which is incorporated herein by reference in its entirety.

### TECHNICAL FIELD

This application relates to the field of electronic technologies, and in particular, to a composite shielding film, an electromagnetic shielding structure, and an electronic device.

### BACKGROUND

With popularization of electronic devices and rapid development of the electronic information industry, electromagnetic wave technologies have been widely applied to many technical fields.

An electronic device usually includes electronic elements (for example, a system on chip (system on chip, SOC) of a mobile phone or a fast charging module) that can emit additional electromagnetic wave signals in a working process. These additional electromagnetic wave signal sources are prone to leakage, and leakage of the electromagnetic wave signals may cause information leakage, interfere with normal running of the electronic device, and even endanger human health.

Therefore, the electromagnetic wave signals need to be shielded to reduce leakage of the electromagnetic wave signals.

### SUMMARY

This application provides a composite shielding film, an electromagnetic shielding structure, and an electronic device. The composite shielding film can shield an electromagnetic wave signal, so that leakage of the electromagnetic wave signal is reduced. Solutions provided in this application are as follows.

According to a first aspect, this application provides a composite shielding film. The composite shielding film includes a first conductive layer, a second conductive layer, and a conductive structure. The first conductive layer and the second conductive layer are opposite to each other and spaced apart from each other, and an orthographic projection region of the second conductive layer on a reference plane parallel to the first conductive layer is located in an orthographic projection region of the first conductive layer on the reference plane. An electrical conductivity of the first conductive layer ranges from 2000 siemens per meter to 80000 siemens per meter. For example, the electrical conductivity of the first conductive layer ranges from 20000 siemens per meter to 80000 siemens per meter, or ranges from 30000 siemens per meter to 50000 siemens per meter. The electrical conductivity of the second conductive layer is greater than or equal to 1000 siemens per meter. For example, the electrical conductivity of the second conductive layer is greater than the electrical conductivity of the first conductive layer. Optionally, the electrical conductivity of the second conductive layer is greater than 100000 siemens per meter, or the electrical conductivity of the second conductive layer is greater than 500000 siemens per meter, or the electrical conductivity of the second conductive layer is greater than 1000000 siemens per meter. The conductive structure is connected to the first conductive layer and the second conductive layer, and is configured to ground the first conductive layer and the second conductive layer.

In this embodiment of this application, when the conductive structure grounds the first conductive layer and the second conductive layer, if the electrical conductivity of the first conductive layer ranges from 2000 siemens per meter (S/m) to 80000 S/m, and the electrical conductivity of the second conductive layer is greater than or equal to 1000 S/m, an electromagnetic wave signal transmitted to the second conductive layer is reflected by the second conductive layer to the first conductive layer. In addition, a part of an electromagnetic wave signal transmitted to the first conductive layer undergoes loss and attenuation on the first conductive layer, and the other part of the electromagnetic wave signal transmitted to the first conductive layer is reflected by the first conductive layer to the second conductive layer. This process is repeated, and the electromagnetic wave signal transmitted to the first conductive layer and/or the second conductive layer is eventually substantially lost. Optionally, when the electrical conductivity of the second conductive layer falls within some ranges, the second conductive layer may also cause loss and attenuation to the electromagnetic wave signal.

It can be learned from the foregoing analysis that the composite shielding film provided in this embodiment of this application can effectively shield an electromagnetic wave signal, which benefits from inclusion of two conductive layers (the first conductive layer and the second conductive layer) and the conductive structure in the composite shielding film. When the conductive structure grounds the two conductive layers, the two conductive layers can converge most of the electromagnetic wave signal to a region between the first conductive layer and the second conductive layer in a case of specific electrical conductivities of the two conductive layers. In addition, the electrical conductivity of the first conductive layer ranges from 2000 S/m to 80000 S/m, to reduce reflection of the electromagnetic wave signal, so that the electromagnetic wave signal enters the first conductive layer to undergo loss.

When the composite shielding film is used as a shielding can in an electromagnetic shielding structure, the conductive structure in the composite shielding film may be connected to a grounding frame, so that the first conductive layer and the second conductive layer are grounded through the conductive structure and the grounding frame. In this way, a part of an electromagnetic wave signal emitted by an electromagnetic wave signal source is shielded at the grounding frame, and cannot be transmitted to the outside of the grounding frame. The other part of the electromagnetic wave signal is transmitted to the first conductive layer and/or the second conductive layer. Then this part of the electromagnetic wave signal is substantially lost on the first conductive layer under the action of the first conductive layer and the second conductive layer. In this way, the electromagnetic wave signal not shielded at the grounding frame is not transmitted to the outside of the electromagnetic shielding structure. It can be learned that the electromagnetic wave signal emitted by the electromagnetic wave signal source can be shielded under the action of the grounding frame and the composite shielding film that is provided in this application.

In the foregoing embodiment, the conductive structure is configured to ground both the first conductive layer and the second conductive layer. It may be understood that the conductive structure may be implemented in various manners, and two of the manners are used as an example for description herein.
1. In a first implementation of the conductive structure, the conductive structure includes a first conductor and a second conductor. The first conductor is located between the first conductive layer and the second conductive layer, and is connected to the first conductive layer and the second conductive layer. The second conductor is located on a side that is of the second conductive layer and that is away from the first conductive layer, and is connected to the second conductive layer, and the second conductor is configured to be grounded. When the composite shielding film is used in the electromagnetic shielding structure, the second conductor may be connected to the grounding frame, so that the second conductor is grounded, thereby implementing grounding of the first conductive layer and the second conductive layer.
2. In a second implementation of the conductive structure, the conductive structure includes a first conductor, a second conductor, and a third conductor. The first conductor is located between the first conductive layer and the second conductive layer, and is connected to the first conductive layer and the second conductive layer. The second conductor is located on a side that is of the second conductive layer and that is away from the first conductive layer, and is connected to the second conductive layer, and the second conductor is configured to be grounded. The third conductor is located on a side that is of the first conductive layer and that is close to the second conductive layer, and an orthographic projection region of the third conductor on the reference plane (a plane parallel to the first conductive layer) is located outside the orthographic projection region of the second conductive layer on the reference plane. The third conductor is connected to the first conductive layer, and the third conductor is also configured to be grounded. When the composite shielding film is used in the electromagnetic shielding structure, both the second conductor and the third conductor may be connected to the grounding frame, so that both the second conductor and the third conductor are grounded, thereby implementing grounding of the first conductive layer and the second conductive layer.

In this application, a material of the conductive structure may be any conductive material (for example, a conductive adhesive, metal, or a conductive inorganic material). This application uses an example in which the material of the conductive structure includes the conductive adhesive. For example, a material of each of the first conductor, the second conductor, and the third conductor may be a conductive adhesive.

Optionally, for an electromagnetic wave signal of 300 megahertz to 10 gigahertz (a frequency of the electromagnetic wave signal is 300 megahertz to 10 megahertz), relative complex permeabilities of the first conductive layer and/or the second conductive layer are greater than or equal to 1. For example, the relative complex permeability is 1, 10, or the like. When the relative complex permeability of the first conductive layer for the electromagnetic wave signal of 300 megahertz to 10 gigahertz is greater than or equal to 1, the first conductive layer can enhance a capability of causing loss and attenuation to the electromagnetic wave signal transmitted to the first conductive layer, thereby improving an effect of shielding the electromagnetic wave signal. When the relative complex permeability of the second conductive layer for the electromagnetic wave signal of 300 megahertz to 10 gigahertz is greater than or equal to 1, the second conductive layer can also cause loss and attenuation to the electromagnetic wave signal transmitted to the second conductive layer. It may be understood that for the electromagnetic wave signal of 300 megahertz to 10 gigahertz, the relative complex permeability of the first conductive layer may alternatively be greater than 1, and the relative complex permeability of the second conductive layer may alternatively be greater than 1. For the electromagnetic wave signal of 300 megahertz to 10 gigahertz, the relative complex permeability of the first conductive layer may alternatively be less than 1, and the relative complex permeability of the second conductive layer may alternatively be less than 1.

Optionally, thickness ranges/a thickness range of the first conductive layer and/or the second conductive layer are/is 1 micrometer to 100 micrometers. The thickness range may include 1 micrometer, or may not include 1 micrometer. The thickness range may include 100 micrometers, or may not include 100 micrometers.

Optionally, a thermal conductivity of the first conductive layer ranges from 1 watt per meter per kelvin to 400 watts per meter per kelvin, and/or a thermal conductivity of the second conductive layer is greater than or equal to 10 watts per meter per kelvin. When the thermal conductivity of the first conductive layer ranges from 1 watt per meter per kelvin to 400 watts per meter per kelvin, the first conductive layer has relatively good thermal performance. When the thermal conductivity of the second conductive layer is greater than or equal to 10 watts per meter per kelvin, the second conductive layer has relatively good thermal performance. In this way, the composite shielding film has a relatively high probability of exhibiting relatively good thermal performance, and heat dissipation of the electromagnetic wave signal source is facilitated when the composite shielding film is used as the shielding can.

The foregoing content uses an example in which the composite shielding film includes one second conductive layer. Optionally, the composite shielding film may include a plurality of second conductive layers, and the plurality of second conductive layers are spaced apart from each other on the plane parallel to the first conductive layer. For each of the plurality of second conductive layers, refer to the second conductive layer described in the foregoing content. Details are not described herein again in this application.

Optionally, the composite shielding film further includes a first insulation layer and/or a second insulation layer. The first insulation layer is located between the first conductive layer and the second conductive layer. The second insulation layer is located on the side that is of the second conductive layer and that is away from the first conductive layer. It may be understood that alternatively, the composite shielding film may not include the first insulation layer and/or the second insulation layer. This is not limited in this application. In this case, the first conductive layer and the second conductive layer are still spaced apart from each other. When the composite shielding film is used in the electromagnetic shielding structure, the second conductive layer and the electromagnetic wave signal source are also spaced apart from each other.

According to a second aspect, this application provides an electromagnetic shielding structure, including a substrate, a grounding frame, an electromagnetic wave signal source, and the composite shielding film according to any design of the first aspect. The grounding frame is grounded, and the grounding frame is located on a target surface of the substrate, and surrounds a target region of the target surface. The composite shielding film is located on a side that is of the grounding frame and that is away from the substrate, and a conductive structure in the composite shielding film is connected to the side that is of the grounding frame and that is away from the substrate. A second conductive layer in the composite shielding film is located between a first conductive layer and the grounding frame; and an orthographic projection region of the target region on a reference plane is located in an orthographic projection region of the second conductive layer on the reference plane. The electromagnetic wave signal source is located between the substrate and the composite shielding film, is located in the target region, and is insulated from both the grounding frame and the composite shielding film.

In this application, both the first conductive layer and the second conductive layer are grounded, the first conductive layer and the second conductive layer form a loop, an electrical conductivity of the first conductive layer ranges from 2000 S/m to 80000 S/m, and an electrical conductivity of the second conductive layer is greater than or equal to 1000 S/m. In this case, a part of an electromagnetic wave signal emitted by the electromagnetic wave signal source is shielded at the grounding frame, and cannot be transmitted to the outside of the grounding frame. The other part of the electromagnetic wave signal is transmitted to the first conductive layer and/or the second conductive layer. Then this part of the electromagnetic wave signal is substantially lost on the first conductive layer under the action of the first conductive layer and the second conductive layer. In this way, the electromagnetic wave signal not shielded at the grounding frame is not transmitted to the outside of the electromagnetic shielding structure. It can be learned that the electromagnetic wave signal emitted by the electromagnetic wave signal source can be shielded under the action of the grounding frame and the composite shielding film.

Optionally, the composite shielding film includes a plurality of second conductive layers, a plurality of target regions exist on the target surface, and the electromagnetic shielding structure includes a plurality of electromagnetic wave signal sources. The plurality of target regions are in one-to-one correspondence with the plurality of second conductive layers, and the orthographic projection region of the target region on the reference plane is located in an orthographic projection region of a corresponding second conductive layer on the reference plane. The plurality of target regions are in one-to-one correspondence with the plurality of electromagnetic wave signal sources, and the electromagnetic wave signal sources are located in the corresponding target regions.

When the composite shielding film includes a plurality of second conductive layers, a part of an electromagnetic wave signal emitted by an electromagnetic wave signal source corresponding to each second conductive layer is shielded at the grounding frame, and the other part of the electromagnetic wave signal is transmitted to the first conductive layer or the second conductive layer, and is substantially lost on the first conductive layer under the action of the first conductive layer and the second conductive layer. It can be learned that when the composite shielding film includes a plurality of second conductive layers, the grounding frame and the composite shielding film can shield electromagnetic wave signals emitted by a plurality of electromagnetic wave signal sources that are in one-to-one correspondence with the plurality of second conductive layers.

Further, the grounding frame in this embodiment of this application may be a closed frame, or may not be a closed frame. For example, when the grounding frame is non-closed, the grounding frame has at least one opening that communicates the target region with the outside of the grounding frame in an extension direction (parallel to the substrate) of the substrate. When the grounding frame has the opening, a region in which the opening is located on the target surface of the substrate may be used to arrange a structure (for example, a chip or a circuit) other than the grounding frame, so that a usable area of the target surface of the substrate is increased. In addition, although the grounding frame has the opening, under the action of the composite shielding film, the electromagnetic wave signal not shielded at the grounding frame is substantially transmitted to the first conductive layer and/or the second conductive layer in the composite shielding film, and is not largely transmitted from the opening to the outside of the electromagnetic shielding structure. It can be learned that the opening of the grounding frame does not greatly affect an electromagnetic shielding function of the electromagnetic shielding structure. If a shielding can is made of a nickel silver material in a related technology, when the grounding frame has the opening, a large quantity of electromagnetic wave signals are transmitted from the opening to the outside of the electromagnetic shielding structure, and therefore, the electromagnetic shielding function of the electromagnetic shielding structure cannot be implemented.

According to a third aspect, this application provides an electronic device, including the electromagnetic shielding structure according to any design of the second aspect.

Optionally, the electronic device is a terminal device, for example, a mobile phone, a tablet computer, a notebook computer, a wearable device (for example, a smartwatch or smart glasses), a car, or a desktop computer. Alternatively, the electronic device may not be a terminal device. For example, the electronic device is a network device (for example, a gateway, a router, or a server).

### BRIEF DESCRIPTION OF DRAWINGS

FIG. 1 is a diagram of a structure of a first composite shielding film according to an embodiment of this application;
FIG. 2 is a diagram of a location relationship between a first conductor and a surface of a side that is of a second conductive layer and that is close to a first conductive layer according to an embodiment of this application;
FIG. 3 is a diagram of a location relationship between a second conductor and a surface of a side that is of a second conductive layer and that is away from a first conductive layer according to an embodiment of this application;
FIG. 4 is a diagram of a structure of a second composite shielding film according to an embodiment of this application;
FIG. 5 is a diagram of a location relationship between both a first conductor and a third conductor and a surface of a side that is of a first conductive layer and that is close to a second conductive layer according to an embodiment of this application;
FIG. 6 is a diagram of a structure of a third composite shielding film according to an embodiment of this application;
FIG. 7 is a diagram of a structure of a fourth composite shielding film according to an embodiment of this application;
FIG. 8 is a diagram of a structure of a fifth composite shielding film according to an embodiment of this application;
FIG. 9 is a diagram of a structure of a sixth composite shielding film according to an embodiment of this application;
FIG. 10 is a diagram of a structure of a seventh composite shielding film according to an embodiment of this application;
FIG. 11 is a diagram of a structure of an eighth composite shielding film according to an embodiment of this application;
FIG. 12 is a diagram of a structure of a ninth composite shielding film according to an embodiment of this application;
FIG. 13 is a diagram of an electromagnetic shielding structure according to an embodiment of this application;
FIG. 14 is a diagram of another electromagnetic shielding structure according to an embodiment of this application;
FIG. 15 is a diagram of a closed grounding frame according to an embodiment of this application; and
FIG. 16 is a diagram of a non-closed grounding frame according to an embodiment of this application.

### DESCRIPTION OF EMBODIMENTS

This application provides a composite shielding film. The composite shielding film is used in an electromagnetic shielding structure in an electronic device, and is configured to shield an electromagnetic wave signal emitted by an electromagnetic wave signal source in the electromagnetic shielding structure, to reduce leakage of the electromagnetic wave signal.

An electronic device in this application may be a terminal device, for example, a mobile phone, a tablet computer, a notebook computer, a wearable device (for example, a smartwatch or smart glasses), a car, or a desktop computer. Alternatively, the electronic device may not be a terminal device. For example, the electronic device is a network device (for example, a gateway, a router, or a server).

The electronic device includes an electromagnetic wave signal source that can emit an electromagnetic wave signal. The electromagnetic wave signal source may be a structure such as one or more chips, one or more circuits, or one or more electronic elements. If the electromagnetic wave signal emitted by the electromagnetic wave signal source leaks, information leakage may be caused, and even human health may be endangered. Therefore, the electromagnetic wave signal needs to be shielded, to shield the electromagnetic wave signal in specific space, so that leakage of the electromagnetic wave signal is reduced.

In a related technology, an electromagnetic wave signal is shielded by using a substrate, a grounding frame, and a shielding can. The grounding frame is fastened on the substrate, the shielding can is fastened on a side that is of the grounding frame and that is away from the substrate, and closed space is enclosed by the shielding can, the grounding frame, and the substrate. An electromagnetic wave signal source is fastened on the substrate, and is located in the closed space. The shielding can, the grounding frame, and the substrate include metal materials, and the metal materials are electrically connected, and are grounded through the grounding frame. In this way, an electromagnetic wave signal emitted by the electromagnetic wave signal source located in the closed space enclosed by the shielding can, the grounding frame, and the substrate can be shielded in the closed space, so that leakage of the electromagnetic wave signal is reduced.

However, a current shielding can is a shielding can of a single material (nickel silver, a copper alloy), and a structure of the shielding can is relatively simple. In addition, both a thickness and a weight of the shielding can of the nickel silver material are relatively large, and consequently, both a volume and a weight of an electronic device in which the substrate, the grounding frame, the shielding can, and the electromagnetic wave signal source are located are relatively large. However, a development trend of the electronic device (especially a terminal device) is miniaturization and lightness. Therefore, the relatively large volume and weight of the electronic device do not conform to the development trend of the electronic device.

In addition, the shielding can in the related technology needs to be strictly grounded to ensure a shielding effect of the electromagnetic wave signal. Therefore, all locations around the shielding can need to be connected to the grounding frame, which in turn results in a relatively large grounding frame that occupies a relatively large area on the substrate. In this case, an area of a region, on the substrate, used to arrange another component is reduced, and consequently, a usable area on the substrate is relatively small.

Therefore, how to reduce a weight and a volume of a material used for shielding and reduce the area occupied by the grounding frame on the substrate become a difficulty in this field.

This application provides a composite shielding film. The composite shielding film may be used as a shielding can, and the composite shielding film is different from a shielding can of a single material, namely, nickel silver, in a related technology. Therefore, a structure of the shielding can be enriched. In addition, in some implementations, both a thickness and a weight of the composite shielding film are relatively small, so that a volume and a weight of an entire electronic device are relatively small, thereby conforming to a development trend of miniaturization and lightness of the electronic device.

In addition, in some implementations, a grounding frame in an electromagnetic shielding structure in which the composite shielding film provided in this application is located may further have an opening, so that an area occupied by a grounding frame on a substrate is reduced, and an area of a region, on the substrate, used to arrange a component other than the grounding frame is increased. In addition, when the grounding frame is provided with the opening, a relatively good electromagnetic shielding effect can be further ensured by using the composite shielding film. Through a test, in some cases, the composite shielding film provided in embodiments of this application also has relatively good thermal performance, and heat dissipation of an electromagnetic wave signal source is facilitated when the composite shielding film is used as a shielding can.

The following separately describes the composite shielding film, the electromagnetic shielding structure in which the composite shielding film is located, and the electronic device that are provided in this application.

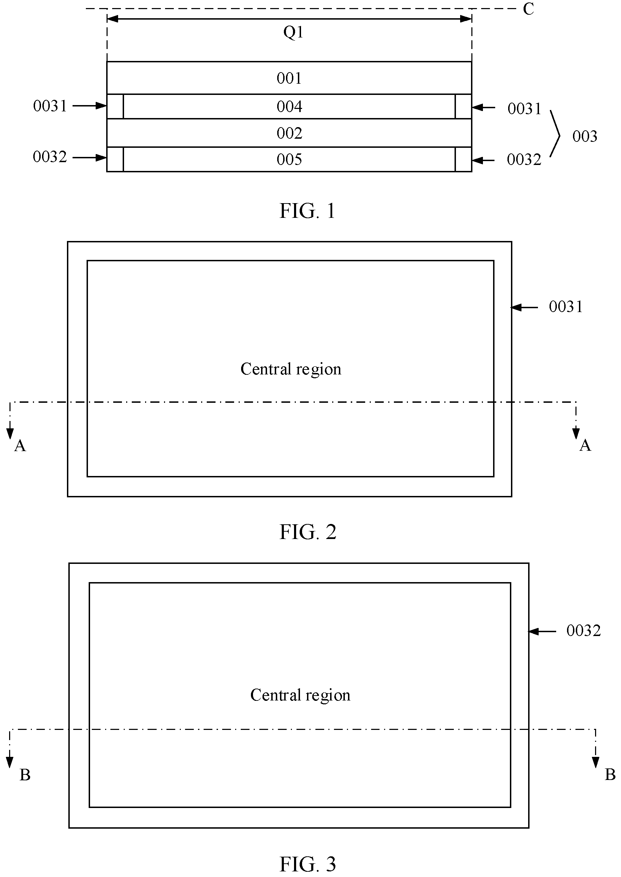

For example, FIG. 1 is a diagram of a structure of a composite shielding film according to an embodiment of this application. As shown in FIG. 1, the composite shielding film includes a first conductive layer 001, a second conductive layer 002, and a conductive structure 003.

The first conductive layer 001 and the second conductive layer 002 are disposed opposite to each other. In other words, the first conductive layer 001 is parallel to the second conductive layer 002, and is arranged in a direction perpendicular to the first conductive layer 001.

An orthographic projection region of the second conductive layer 002 on a reference plane C parallel to the first conductive layer 001 is located in an orthographic projection region of the first conductive layer 001 on the reference plane C. It can be learned that an area of the first conductive layer 001 is relatively large, and an area of the second conductive layer 002 is relatively small; or an area of the first conductive layer 001 is the same as an area of the second conductive layer 002. FIG. 1 uses an example in which the orthographic projection region of the first conductive layer 001 on the reference plane C and the orthographic projection region of the second conductive layer 002 on the reference plane C coincide with each other, and both are a region Q1.

An electrical conductivity of the first conductive layer 001 ranges from 2000 siemens per meter (S/m) to 80000 siemens per meter. The range may include 2000 S/m, or may not include 2000 S/m. The range may include 80000 S/m, or may not include 80000 S/m. For example, assuming that the electrical conductivity of the first conductive layer 001 is X, 2000 S/m≤X≤80000 S/m, or 2000 S/m<X≤80000 S/m, or 2000 S/m≤X<80000 S/m, or 2000 S/m<X<80000 S/m. An electrical conductivity of the second conductive layer 002 is greater than or equal to 1000 siemens per meter, and the electrical conductivity of the second conductive layer 002 may alternatively be greater than 1000 S/m.

For example, the electrical conductivity of the first conductive layer 001 may be 2000 S/m, 10000 S/m, 20000 S/m, 80000 S/m, or the like, and the electrical conductivity of the second conductive layer 002 may be 1000 S/m, 1x10⁶ S/m, 4x10⁶ S/m, 3x10⁶ S/m, or the like.

Optionally, the electrical conductivity of the first conductive layer 001 may not range from 2000 S/m to 80000 S/m. For example, the electrical conductivity of the first conductive layer ranges from 20000 S/m to 80000 S/m, from 30000 S/m to 50000 S/m, from 30000 S/m to 80000 S/m, from 20000 S/m to 50000 S/m, from 40000 S/m to 50000 S/m, or the like. This is not limited in embodiments of this application.

When the electrical conductivity of the first conductive layer ranges from 20000 S/m to 80000 S/m, the electrical conductivity of the first conductive layer may be 30000 S/m, 40000 S/m, 50000 S/m, or the like. When the electrical conductivity of the first conductive layer ranges from 30000 S/m to 50000 S/m, the electrical conductivity of the first conductive layer may be 40000 S/m, 45000 S/m, or the like. When the electrical conductivity of the first conductive layer ranges from 30000 S/m to 80000 S/m, the electrical conductivity of the first conductive layer may be 50000 S/m, 60000 S/m, or the like. When the electrical conductivity of the first conductive layer ranges from 20000 S/m to 50000 S/m, the electrical conductivity of the first conductive layer may be 30000 S/m, 40000 S/m, or the like. When the electrical conductivity of the first conductive layer ranges from 40000 S/m to 50000 S/m, the electrical conductivity of the first conductive layer may be 45000 S/m, 46000 S/m, or the like.

Optionally, the electrical conductivity of the second conductive layer 002 is greater than the electrical conductivity of the first conductive layer 001. For example, the electrical conductivity of the second conductive layer 002 is greater than 100000 siemens per meter, or the electrical conductivity of the second conductive layer 002 is greater than 500000 siemens per meter, or the electrical conductivity of the second conductive layer 002 is greater than 1000000 siemens per meter.

When the electrical conductivity of the second conductive layer is greater than 100000 S/m, the electrical conductivity of the second conductive layer may be 110000 S/m, 120000 S/m, 130000 S/m, or the like. When the electrical conductivity of the second conductive layer is greater than 500000 S/m, the electrical conductivity of the second conductive layer may be 600000 S/m, 700000 S/m, 800000 S/m, or the like. When the electrical conductivity of the second conductive layer is greater than 1000000 S/m, the electrical conductivity of the second conductive layer may be 1100000 S/m, 1200000 S/m, 1300000 S/m, or the like. In this embodiment of this application, the electrical conductivity of the second conductive layer 002 may alternatively be less than or equal to the electrical conductivity of the first conductive layer 001. For example, the electrical conductivity of the second conductive layer 002 may be greater than 1000 S/m and less than 2000 S/m. This is not limited in embodiments of this application.

The conductive structure 003 is connected to the first conductive layer 001 and the second conductive layer 002, and is configured to ground the first conductive layer 001 and the second conductive layer 002. For example, in FIG. 1, a first conductor 0031 in the conductive structure 003 is connected to the first conductive layer 001 and the second conductive layer 002, and is configured to ground both the first conductive layer 001 and the second conductive layer 002; and a second conductor 0032 in the conductive structure 003 is connected to the second conductive layer 002, is grounded, and is configured to ground the first conductive layer 001 and the second conductive layer 002.

In this embodiment of this application, when the conductive structure 003 grounds the first conductive layer 001 and the second conductive layer 002, if the electrical conductivity of the first conductive layer 001 ranges from 2000 S/m to 80000 S/m, and the electrical conductivity of the second conductive layer 002 is greater than or equal to 1000 S/m, an electromagnetic wave signal transmitted to the second conductive layer 002 is reflected by the second conductive layer 002 to the first conductive layer 001. In addition, a part of an electromagnetic wave signal transmitted to the first conductive layer 001 undergoes loss and attenuation on the first conductive layer 001, and the other part of the electromagnetic wave signal transmitted to the first conductive layer 001 is reflected by the first conductive layer 001 to the second conductive layer 002. This process is repeated, and the electromagnetic wave signal transmitted to the first conductive layer 001 and/or the second conductive layer 002 is eventually substantially lost. Optionally, when the electrical conductivity of the second conductive layer 002 falls within some ranges, the second conductive layer 002 may also cause loss and attenuation to the electromagnetic wave signal.

It can be learned from the foregoing analysis that the composite shielding film provided in this embodiment of this application can effectively shield an electromagnetic wave signal, which benefits from inclusion of two conductive layers (the first conductive layer and the second conductive layer) and the conductive structure in the composite shielding film. When the conductive structure grounds the two conductive layers, the two conductive layers can converge most of the electromagnetic wave signal to a region between the first conductive layer and the second conductive layer in a case of specific electrical conductivities of the two conductive layers. In addition, the electrical conductivity of the first conductive layer ranges from 2000 S/m to 80000 S/m, to reduce reflection of the electromagnetic wave signal, so that the electromagnetic wave signal enters the first conductive layer to undergo loss.

When the composite shielding film is used as a shielding can in an electromagnetic shielding structure, the conductive structure 003 in the composite shielding film may be connected to a grounding frame, so that the first conductive layer 001 and the second conductive layer 002 are grounded through the conductive structure 003 and the grounding frame. In this way, a part of an electromagnetic wave signal emitted by an electromagnetic wave signal source is shielded at the grounding frame, and cannot be transmitted to the outside of the grounding frame. The other part of the electromagnetic wave signal is transmitted to the first conductive layer 001 and/or the second conductive layer 002. Then this part of the electromagnetic wave signal is substantially lost on the first conductive layer 001 under the action of the first conductive layer 001 and the second conductive layer 002. In this way, the electromagnetic wave signal not shielded at the grounding frame is not transmitted to the outside of the electromagnetic shielding structure. It can be learned that the electromagnetic wave signal emitted by the electromagnetic wave signal source can be shielded under the action of the grounding frame and the composite shielding film that is provided in this application.

Optionally, for an electromagnetic wave signal of 300 megahertz to 10 gigahertz (a frequency of the electromagnetic wave signal is 300 megahertz to 10 megahertz), relative complex permeabilities/a relative complex permeability of the first conductive layer 001 and/or the second conductive layer 002 are/is greater than or equal to 1. For example, the relative complex permeability is 1, 10, or the like. When the relative complex permeability of the first conductive layer 001 for the electromagnetic wave signal of 300 megahertz to 10 gigahertz is greater than or equal to 1, the first conductive layer 001 can enhance a capability of causing loss and attenuation to the electromagnetic wave signal transmitted to the first conductive layer 001, thereby improving an effect of shielding the electromagnetic wave signal. When the relative complex permeability of the second conductive layer 002 for the electromagnetic wave signal of 300 megahertz to 10 gigahertz is greater than or equal to 1, the second conductive layer 002 can also cause loss and attenuation to the electromagnetic wave signal transmitted to the second conductive layer 002. It may be understood that for the electromagnetic wave signal of 300 megahertz to 10 gigahertz, the relative complex permeability of the first conductive layer 001 may alternatively be greater than 1, and the relative complex permeability of the second conductive layer 002 may alternatively be greater than 1. For the electromagnetic wave signal of 300 megahertz to 10 gigahertz, the relative complex permeability of the first conductive layer 001 may alternatively be less than 1, and the relative complex permeability of the second conductive layer 002 may alternatively be less than 1.

In the foregoing embodiment, the conductive structure 003 is configured to ground both the first conductive layer 001 and the second conductive layer 002. It may be understood that the conductive structure 003 may be implemented in various manners, and two of the manners are used as an example for description herein.
1. In a first implementation of the conductive structure 003, still refer to FIG. 1. The conductive structure 003 includes the first conductor 0031 and the second conductor 0032. The first conductor 0031 is located between the first conductive layer 001 and the second conductive layer 002, and is connected to the first conductive layer 001 and the second conductive layer 002. The second conductor 0032 is located on a side that is of the second conductive layer 002 and that is away from the first conductive layer 001, and is connected to the second conductive layer 002, and the second conductor 0032 is configured to be grounded. When the composite shielding film is used in the electromagnetic shielding structure, the second conductor 0032 may be connected to the grounding frame, so that the second conductor 0032 is grounded, thereby implementing grounding of the first conductive layer 001 and the second conductive layer 002.

The first conductor 0031 may be connected to an edge region of a surface of a side that is of the first conductive layer 001 and that is close to the second conductive layer 002 (this is used as an example in FIG. 1), or the first conductor 0031 may be connected to a non-edge region of a surface of a side that is of the first conductive layer 001 and that is close to the second conductive layer 002.

The first conductor 0031 may be connected to an edge region of a surface of a side that is of the second conductive layer 002 and that is close to the first conductive layer 001 (this is used as an example in FIG. 1), or the first conductor 0031 may be connected to a non-edge region of a surface of a side that is of the second conductive layer 002 and that is close to the first conductive layer 001.

The second conductor 0032 may be connected to an edge region of a surface of the side that is of the second conductive layer 002 and that is away from the first conductive layer 001 (this is used as an example in FIG. 1), or the second conductor 0032 may be connected to a non-edge region of a surface of the side that is of the second conductive layer 002 and that is away from the first conductive layer 001.

For example, FIG. 2 is a diagram of a location relationship between the first conductor 0031 and the surface of the side that is of the second conductive layer 002 and that is close to the first conductive layer 001 according to an embodiment of this application. The structure shown in FIG. 1 includes a structure at a cross-section AA in FIG. 2. As shown in FIG. 2, when the first conductor 0031 is connected to the edge region of the surface of the side that is of the second conductive layer 002 and that is close to the first conductive layer 001, the edge region is ring-shaped (a square ring, a circular ring, or an irregular ring), the first conductor 0031 may also be ring-shaped, and an orthographic projection region of the first conductor 0031 on the surface surrounds a central region surrounded by the edge region. The orthographic projection region of the first conductor 0031 on the surface is located in the edge region. For example, the orthographic projection region of the first conductor 0031 on the surface is the edge region. It may be understood that when the first conductor 0031 is connected to the edge region of the surface of the side that is of the second conductive layer 002 and that is close to the first conductive layer 001, the first conductor 0031 may not be ring-shaped. For example, the first conductor 0031 is semi-ring-shaped, strip-shaped, irregularly shaped, or the like. This is not limited in embodiments of this application.

For another example, FIG. 3 is a diagram of a location relationship between the second conductor 0032 and the surface of the side that is of the second conductive layer 002 and that is away from the first conductive layer 001 according to an embodiment of this application. The structure shown in FIG. 1 includes a structure at a cross-section BB in FIG. 3. As shown in FIG. 3, when the second conductor 0032 is connected to the edge region of the surface of the side that is of the second conductive layer 002 and that is away from the first conductive layer 001, the edge region is ring-shaped (a square ring, a circular ring, or an irregular ring), the second conductor 0032 may also be ring-shaped, and an orthographic projection region of the second conductor 0032 on the surface surrounds a central region surrounded by the edge region. The orthographic projection region of the second conductor 0032 on the surface is located in the edge region. For example, the orthographic projection region of the second conductor 0032 on the surface is the edge region. It may be understood that when the second conductor 0032 is connected to the edge region of the surface of the side that is of the second conductive layer 002 and that is away from the first conductive layer 001, the second conductor 0032 may not be ring-shaped. For example, the second conductor 0032 is semi-ring-shaped, strip-shaped, irregularly shaped, or the like. This is not limited in embodiments of this application.

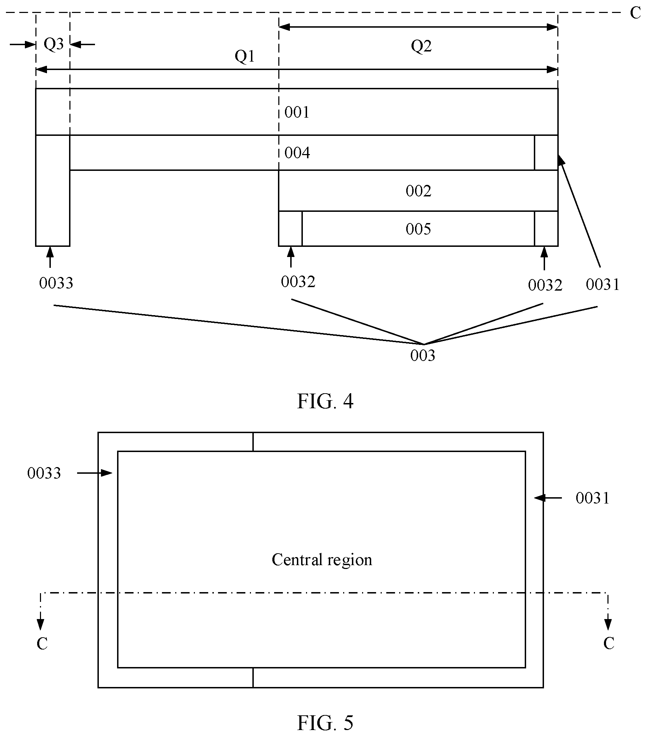

2. In a second implementation of the conductive structure 003, refer to FIG. 4. The conductive structure 003 includes the first conductor 0031, the second conductor 0032, and a third conductor 0033. The first conductor 0031 is located between the first conductive layer 001 and the second conductive layer 002, and is connected to the first conductive layer 001 and the second conductive layer 002. The second conductor 0032 is located on a side that is of the second conductive layer 001 and that is away from the first conductive layer 001, and is connected to the second conductive layer 002, and the second conductor 0032 is configured to be grounded. The third conductor 0033 is located on a side that is of the first conductive layer 001 and that is close to the second conductive layer 002, and an orthographic projection region Q3 of the third conductor 0033 on the reference plane C (a plane parallel to the first conductive layer 001) is located outside an orthographic projection region Q2 of the second conductive layer 002 on the reference plane C. The third conductor 0033 is connected to the first conductive layer 001, and the third conductor 0033 is also configured to be grounded. When the composite shielding film is used in the electromagnetic shielding structure, both the second conductor 0032 and the third conductor 0033 may be connected to the grounding frame, so that both the second conductor 0032 and the third conductor 0033 are grounded, thereby implementing grounding of the first conductive layer 001 and the second conductive layer 002.

The first conductor 0031 and the third conductor 0033 in the second implementation may be combined into a conductor (referred to as a fourth conductor). A part (the first conductor 0031) of the fourth conductor is located between the first conductive layer 001 and the second conductive layer 002, and is connected to the first conductive layer 001 and the second conductive layer 002. The other part (the third conductor 0033) of the fourth conductor is located on the side that is of the first conductive layer 001 and that is close to the second conductive layer 002, and the orthographic projection region Q3 of the other part on the reference plane C is located outside the orthographic projection region Q2 of the second conductive layer 002 on the reference plane C. The other part is connected to the first conductive layer 001, and the other part is also configured to be grounded.

In the second implementation, an area of the orthographic projection region Q1 of the first conductive layer 001 on the reference plane is greater than an area of the orthographic projection region Q2 of the second conductive layer 002 on the reference plane. In this way, the first conductive layer 001 may have a part protruding from the second conductive layer 002, and the third conductor 0033 may be connected to a surface of a side that is of the part and that is close to the second conductive layer 002. A surface, of a part that is of the first conductive layer 001 and that does not protrude from the second conductive layer 002, close to the second conductive layer 002 may be connected to the first conductor 0031.

The first conductor 0031 and the third conductor 0033 are connected to different regions of a surface that is of the first conductive layer 001 and that is close to the second conductive layer 002. The first conductor 0031 and the third conductor 0033 may be connected to each other, or may not be connected to each other, and this embodiment of this application uses an example in which the first conductor 0031 is connected to the third conductor 0033. Optionally, the first conductor 0031 and the third conductor 0033 may be connected as an integral piece.

The first conductor 0031 may be connected to an edge region of a surface of the side that is of the first conductive layer 001 and that is close to the second conductive layer 002 (this is used as an example in FIG. 1), or the first conductor 0031 may be connected to a non-edge region of a surface of the side that is of the first conductive layer 001 and that is close to the second conductive layer 002.

The first conductor 0031 may be connected to an edge region of a surface of a side that is of the second conductive layer 002 and that is close to the first conductive layer 001 (this is used as an example in FIG. 4), or the first conductor 0031 may be connected to a non-edge region of a surface of a side that is of the second conductive layer 002 and that is close to the first conductive layer 001.

The second conductor 0032 may be connected to an edge region of a surface of the side that is of the second conductive layer 002 and that is away from the first conductive layer 001 (this is used as an example in FIG. 4), or the second conductor 0032 may be connected to a non-edge region of a surface of the side that is of the second conductive layer 002 and that is away from the first conductive layer 001.

The third conductor 0033 may be connected to the edge region of the surface of the side that is of the first conductive layer 001 and that is close to the second conductive layer 002 (this is used as an example in FIG. 4), or the third conductor 0033 may be connected to the non-edge region of the surface of the side that is of the first conductive layer 001 and that is close to the second conductive layer 002.

For example, FIG. 5 is a diagram of a location relationship between both the first conductor 0031 and the third conductor 0033 and the surface of the side that is of the first conductive layer 001 and that is close to the second conductive layer 002 according to an embodiment of this application. The structure shown in FIG. 4 includes a structure at a cross-section CC in FIG. 5. As shown in FIG. 5, when both the first conductor 0031 and the third conductor 0033 are connected to the edge region of the surface of the side that is of the first conductive layer 001 and that is close to the second conductive layer 002, the edge region is ring-shaped (a square ring, a circular ring, or an irregular ring, where the square ring is used as an example in FIG. 5), the integral piece formed by connecting the first conductor 0031 and the third conductor 0033 may also be ring-shaped, and an orthographic projection region of the integral piece on the surface surrounds a central region surrounded by the edge region. The orthographic projection region of the integral piece on the surface is located in the edge region. For example, the orthographic projection region of the integral piece on the surface is the edge region. It may be understood that the integral piece may not be ring-shaped. For example, the integral piece is semi-ring-shaped, strip-shaped, irregularly shaped, or the like. In addition, the first conductor 0031 and the third conductor 0033 may not be connected to each other. This is not limited in embodiments of this application.

For another example, for a diagram of a location relationship between the second conductor 0032 and the surface of the side that is of the second conductive layer 002 and that is away from the first conductive layer 001, refer to FIG. 3. Details are not described herein again in this embodiment of this application.

In the foregoing embodiment, a conductor (for example, the first conductor) connected to both the first conductive layer 001 and the second conductive layer 002 exists in the conductive structure 003. The conductive structure 003 electrically connects the first conductive layer 001 to the second conductive layer 002 through the conductor, and then grounds the second conductive layer 002 through another conductor (for example, the second conductor or the third conductor), so that the first conductive layer 001 and the second conductive layer 002 are grounded. It may be understood that the conductive structure 003 may not include the conductor connected to both the first conductive layer 001 and the second conductive layer 002.

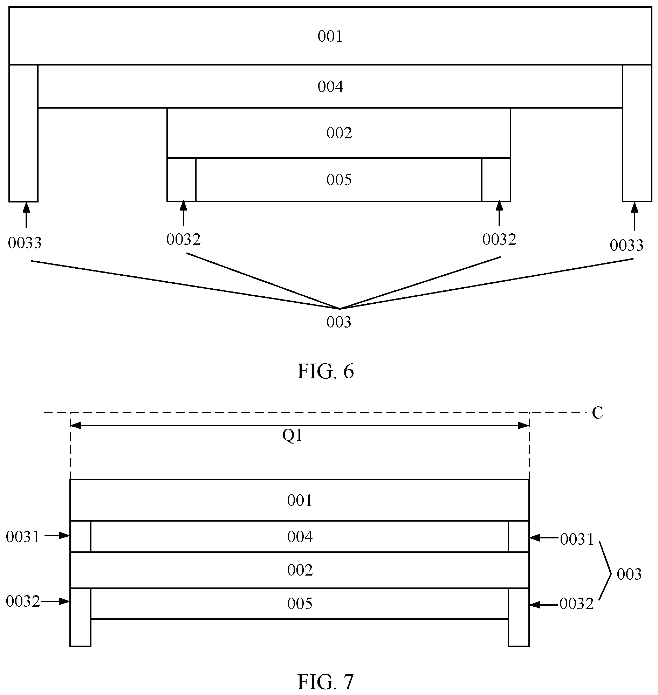

For example, as shown in FIG. 6, the conductive structure 003 includes the second conductor 0032 and the third conductor 0033, but does not include the first conductor. In this case, when the composite shielding film is used in the electromagnetic shielding structure, both the second conductor 0032 and the third conductor 0033 may be connected to the grounding frame. In this way, both the first conductive layer and the second conductive layer are grounded through the grounding frame.

The conductive structure 003 may be implemented in more manners. The manners are not listed in this embodiment of this application.

In this embodiment of this application, a material of the conductive structure 003 may be any conductive material (for example, a conductive adhesive, metal, or a conductive inorganic material). This embodiment of this application uses an example in which the material of the conductive structure 003 includes the conductive adhesive. For example, a material of each of the first conductor 0031, the second conductor 0032, and the third conductor 0033 may be a conductive adhesive.

Optionally, thickness ranges/a thickness range of the first conductive layer 001 and/or the second conductive layer 002 are/is 1 micrometer to 100 micrometers. The thickness range may include 1 micrometer, or may not include 1 micrometer. The thickness range may include 100 micrometers, or may not include 100 micrometers. Assuming that thicknesses of the first conductive layer 001 and/or the second conductive layer 002 are Y, 1 micrometer≤Y≤100 micrometers, or 1 micrometer<Y≤100 micrometers, or 1 micrometer≤Y<100 micrometers, or 1 micrometer<Y<100 micrometers.

For example, the thickness of the first conductive layer 001 may be 1 micrometer, and the thickness of the second conductive layer 002 is 10 micrometers; or the thickness of the first conductive layer 001 may be 10 micrometers, and the thickness of the second conductive layer 002 is 10 micrometers; or the thickness of the first conductive layer 001 may be 50 micrometers, and the thickness of the second conductive layer 002 is 40 micrometers; or the thickness of the first conductive layer 001 may be 100 micrometers, and the thickness of the second conductive layer 002 is 100 micrometers; or the thickness of the first conductive layer 001 may be 40 micrometers, and the thickness of the second conductive layer 002 may be 50 micrometers.

Alternatively, the thickness ranges of the first conductive layer 001 and the second conductive layer 002 may not be 1 micrometer to 100 micrometers. This is not limited in embodiments of this application.

Optionally, a thickness of the composite shielding film (a distance between a surface of a side that is of the first conductive layer 001 and that is away from the second conductive layer 002 and the surface of the side that is of the second conductive layer 002 and that is away from the first conductive layer 001) may be less than 150 micrometers. For example, the thickness of the composite shielding film is less than 100 micrometers. Certainly, the thickness of the composite shielding film may alternatively be greater than or equal to 150 micrometers.

A shielding can in a related technology is made of a nickel silver material, and a thickness of the shielding can is approximately 150 micrometers. If the thickness of the composite shielding film in this application is less than 150 micrometers, it indicates that the thickness of the composite shielding film provided in this embodiment of this application is less than the thickness of the shielding can of the nickel silver material in the related technology. When the composite shielding film is used in the shielding can in the electromagnetic shielding structure, a thickness of the entire electromagnetic shielding structure is relatively small. This facilitates a reduction in a volume of the electromagnetic shielding structure.

Optionally, still refer to FIG. 1 or FIG. 3. The composite shielding film further includes a first insulation layer 004 and a second insulation layer 005. The first insulation layer 004 is located between the first conductive layer 001 and the second conductive layer 002, and is configured to separate the first conductive layer 001 from the second conductive layer 002. The second insulation layer 005 is located on the side that is of the second conductive layer 002 and that is away from the first conductive layer 001, and is configured to insulate the second conductive layer 002 from the electromagnetic wave signal source when the composite shielding film is used in the electromagnetic shielding structure. When the composite shielding film is used in the electromagnetic shielding structure, the second insulation layer 005 and the electromagnetic wave signal source may be in contact with each other, or may be spaced apart from each other. This is not limited in embodiments of this application. Alternatively, the composite shielding film provided in this embodiment of this application may not include one or more of the first insulation layer 004 and the second insulation layer 005. This is not limited in embodiments of this application.

In addition, this embodiment of this application uses an example in which a side that is of the second insulation layer 005 and that is away from the first conductive layer 001 is flush with a side that is of the conductive structure 003 and that is away from the first conductive layer 001. It may be understood that the side that is of the conductive structure 003 and that is away from the first conductive layer 001 may alternatively protrude from the side that is of the second insulation layer 005 and that is away from the first conductive layer 001.

For example, if in the composite shielding film shown in FIG. 1, the side that is of the conductive structure 003 and that is away from the first conductive layer 001 protrudes from the side that is of the second insulation layer 005 and that is away from the first conductive layer 001, a structure of the composite shielding film may be shown in FIG. 7.

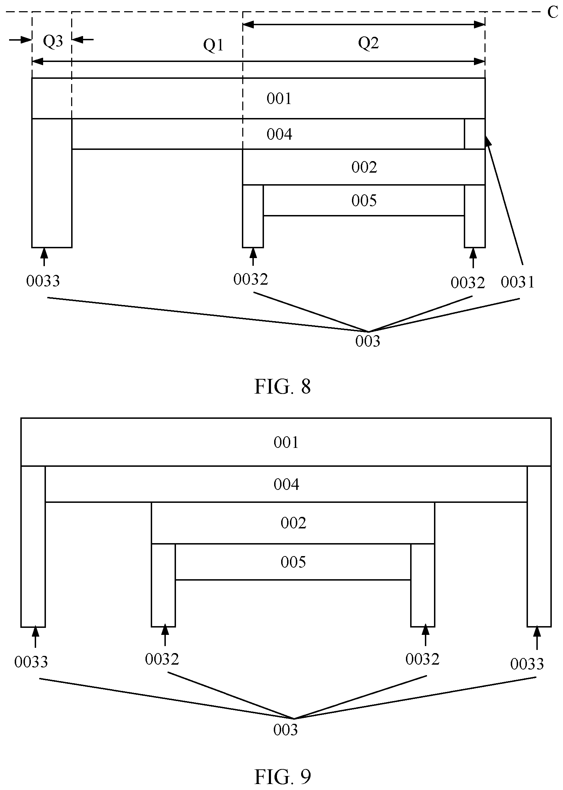

If in the composite shielding film shown in FIG. 4, the side that is of the conductive structure 003 and that is away from the first conductive layer 001 protrudes from the side that is of the second insulation layer 005 and that is away from the first conductive layer 001, a structure of the composite shielding film may be shown in FIG. 8.

If in the composite shielding film shown in FIG. 6, the side that is of the conductive structure 003 and that is away from the first conductive layer 001 protrudes from the side that is of the second insulation layer 005 and that is away from the first conductive layer 001, a structure of the composite shielding film may be shown in FIG. 9.

It may be understood that alternatively, the composite shielding film may not include the first insulation layer 004 and/or the second insulation layer 005. This is not limited in embodiments of this application. In this case, the first conductive layer 001 and the second conductive layer 002 are still spaced apart from each other. When the composite shielding film is used in the electromagnetic shielding structure, the second conductive layer 002 and the electromagnetic wave signal source are also spaced apart from each other.

Further, in this embodiment of this application, materials of the first conductive layer 001 and the second conductive layer 002 may be any conductive materials, for example, a carbon material, an organic material, a metal material, or a non-metal material. Materials of the first insulation layer 004 and the second insulation layer 005 may be any insulation materials, for example, an organic material or a non-metal material. The carbon material, the organic material, and the non-metal material are usually relatively small in weight, and therefore, the composite shielding film can be relatively small in weight. The material of the first conductive layer 001 and the material of the second conductive layer 002 may be the same or different, and the material of the first insulation layer 004 and the material of the second insulation layer 005 may be the same or different.

Optionally, a thermal conductivity of the first conductive layer 001 ranges from 1 watt per meter per kelvin to 400 watts per meter per kelvin, and/or a thermal conductivity of the second conductive layer 002 is greater than or equal to 10 watts per meter per kelvin. When the thermal conductivity of the first conductive layer 001 ranges from 1 watt per meter per kelvin to 400 watts per meter per kelvin, the material of the first conductive layer 001 may be a conductive material such as a conductive polymer, a carbon nanotube, graphene, or MXenes (MXenes are transition metal carbides/nitrides with a two-dimensional layered structure, and are a new type of material). When the thermal conductivity of the second conductive layer 002 is greater than or equal to 10 watts per meter per kelvin, the material of the second conductive layer 002 may be a conductive material such as a conductive polymer, a carbon nanotube, graphene, MXenes, or metal foil. When the thermal conductivity of the first conductive layer 001 ranges from 1 watt per meter per kelvin to 400 watts per meter per kelvin, the first conductive layer 001 has relatively good thermal performance. When the thermal conductivity of the second conductive layer 002 is greater than or equal to 10 watts per meter per kelvin, the second conductive layer 002 has relatively good thermal performance. In this way, the composite shielding film has a relatively high probability of exhibiting relatively good thermal performance, and heat dissipation of the electromagnetic wave signal source is facilitated when the composite shielding film is used as the shielding can.

It may be understood that alternatively, the thermal conductivity of the first conductive layer 001 may not range from 1 watt per meter per kelvin to 400 watts per meter per kelvin, and the thermal conductivity of the second conductive layer 002 may be less than 10 watts per meter per kelvin. This is not limited in embodiments of this application.

The foregoing embodiment uses an example in which the composite shielding film includes one second conductive layer 002. Optionally, the composite shielding film may include a plurality of second conductive layers 002, and the plurality of second conductive layers 002 are spaced apart from each other on the plane parallel to the first conductive layer 001. For each of the plurality of second conductive layers 002, refer to the second conductive layer 002 described in the foregoing embodiment. Details are not described herein again in this embodiment of this application.

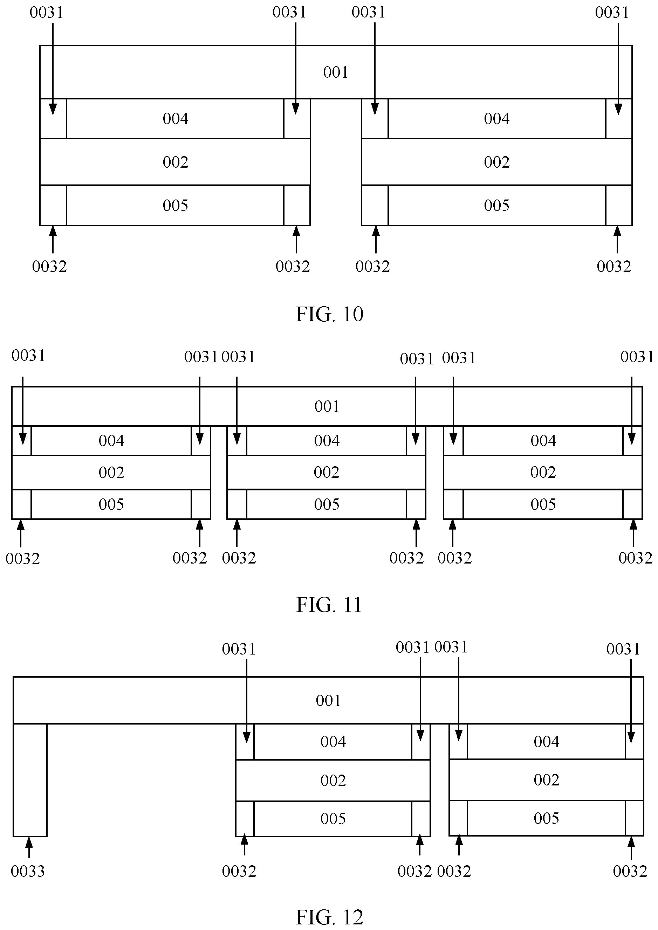

For example, if the composite shielding film shown in FIG. 1 includes a plurality of second conductive layers 002, a structure of the composite shielding film may be shown in FIG. 10 or FIG. 11. An example in which the composite shielding film includes two second conductive layers 002 is used in FIG. 10, and an example in which the composite shielding film includes three second conductive layers 002 is used in FIG. 11.

If the composite shielding film shown in FIG. 4 includes a plurality of second conductive layers 002, a structure of the composite shielding film may be shown in FIG. 12.

It may be understood that the composite shielding film including the plurality of second conductive layers 002 may alternatively be different from the composite shielding films shown in FIG. 10, FIG. 11, and FIG. 12. This is not limited in embodiments of this application.

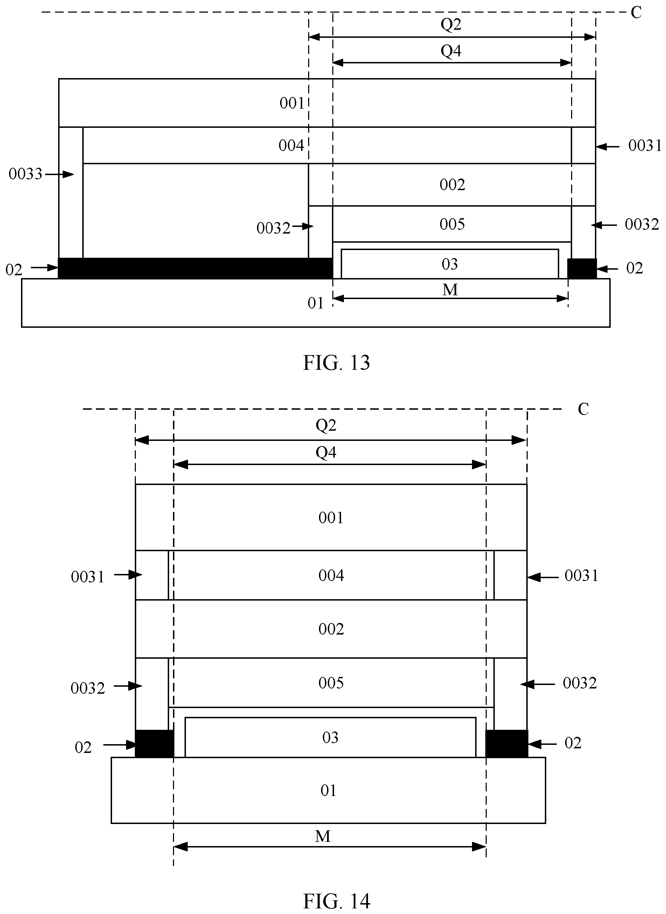

Based on the composite shielding film provided in embodiments of this application, an embodiment of this application further provides an electromagnetic shielding structure including the composite shielding film. For example, FIG. 13 is a diagram of an electromagnetic shielding structure according to an embodiment of this application. As shown in FIG. 13, the electromagnetic shielding structure includes a substrate 01, a grounding frame 02, an electromagnetic wave signal source 03, and a composite shielding film. The composite shielding film may be any one of the composite shielding films provided in the foregoing embodiments (the composite shielding film shown in FIG. 1, FIG. 4, FIG. 6, FIG. 7, FIG. 8, FIG. 9, FIG. 10, FIG. 11, or FIG. 12, where the composite shielding film shown in FIG. 4 is used as an example in FIG. 13). For example, when the electromagnetic shielding structure includes the composite shielding film shown in FIG. 1, a diagram of the electromagnetic shielding structure is shown in FIG. 14.

The substrate 01 may include a plurality of substrate insulation layers and at least one substrate conductive layer sandwiched between the substrate insulation layers. The substrate may be a printed circuit board (printed circuit board, PCB).

Refer to FIG. 13 or FIG. 14. The grounding frame 02 is grounded. The grounding frame 02 is located on a target surface of the substrate 01, and surrounds a target region M of the target surface. The grounding frame 02 may be electrically connected to a grounded substrate conductive layer in the substrate, to implement grounding of the grounding frame 02. Certainly, the grounding frame 02 may alternatively be grounded in another manner. For example, the grounding frame is grounded by connecting to a ground trace on the target surface of the substrate. This is not limited in embodiments of this application.

The composite shielding film is located on a side that is of the grounding frame 02 and that is away from the substrate 01, and a conductive structure 003 in the composite shielding film is connected to the side that is of the grounding frame 02 and that is away from the substrate 01. A second conductive layer 002 in the composite shielding film is located between a first conductive layer 001 and the grounding frame 02. An orthographic projection region Q4 of the target region M on a reference plane C is located in an orthographic projection region Q2 of the second conductive layer 002 on the reference plane C. The electromagnetic wave signal source 03 is located between the substrate 01 and the composite shielding film, is located in the target region M, and is insulated from both the grounding frame 02 and the composite shielding film.

It can be learned that both the grounding frame 02 and the electromagnetic wave signal source 03 are located on the target surface of the substrate 01. The electromagnetic wave signal source 03 is located in the target region of the target surface, the grounding frame 02 surrounds the target region, and the grounding frame 02 and the electromagnetic wave signal source 03 are spaced apart from each other. The composite shielding film covers a side that is of the grounding frame 02 and the electromagnetic wave signal source 03 and that is away from the substrate 01. In addition, the second conductive layer 002 in the composite shielding film is closer to the substrate 01 than the first conductive layer 001. The conductive structure 003 in the composite shielding film is connected to the side that is of the grounding frame 02 and that is away from the substrate 01, so that both the first conductive layer 001 and the second conductive layer 002 are grounded.

In this embodiment of this application, both the first conductive layer 001 and the second conductive layer 002 are grounded, the first conductive layer 001 and the second conductive layer 002 form a loop, an electrical conductivity of the first conductive layer 001 ranges from 2000 S/m to 80000 S/m, and an electrical conductivity of the second conductive layer 002 is greater than or equal to 1000 S/m. In this case, a part of an electromagnetic wave signal emitted by the electromagnetic wave signal source is shielded at the grounding frame 02, and cannot be transmitted to the outside of the grounding frame 02. The other part of the electromagnetic wave signal is transmitted to the first conductive layer 001 and/or the second conductive layer 002. Then this part of the electromagnetic wave signal is substantially lost on the first conductive layer 001 under the action of the first conductive layer 001 and the second conductive layer 002. In this way, the electromagnetic wave signal not shielded at the grounding frame 02 is not transmitted to the outside of the electromagnetic shielding structure. It can be learned that the electromagnetic wave signal emitted by the electromagnetic wave signal source 03 can be shielded under the action of the grounding frame 02 and the composite shielding film.

Optionally, the composite shielding film in the foregoing embodiment may include one or more second conductive layers. Correspondingly, one or more target regions exist on the target surface, and the electromagnetic shielding structure includes one or more electromagnetic wave signal sources.

For example, when the composite shielding film includes a plurality of second conductive layers 002, a plurality of target regions M exist on the target surface of the substrate 01, and the electromagnetic shielding structure includes a plurality of electromagnetic wave signal sources 03. The plurality of target regions M are in one-to-one correspondence with the plurality of second conductive layers 002, and an orthographic projection region of the target region M on the reference plane C is located in an orthographic projection region of a corresponding second conductive layer 002 on the reference plane C. The plurality of target regions M are in one-to-one correspondence with the plurality of electromagnetic wave signal sources 03, and the electromagnetic wave signal sources 03 are located in the corresponding target regions M. In this case, the grounding frame 02 surrounds each of the plurality of target regions M, the grounding frame 02 may have a plurality of hollow regions that are in one-to-one correspondence with the plurality of target regions M, and each target region M is located in a corresponding hollow region. Optionally, the orthographic projection region of the target region M on the reference plane may overlap an orthographic projection region of the hollow region on the reference plane.

When the composite shielding film includes a plurality of second conductive layers 002, a part of an electromagnetic wave signal emitted by an electromagnetic wave signal source 03 corresponding to each second conductive layer 002 is shielded at the grounding frame 02, and the other part of the electromagnetic wave signal is transmitted to the first conductive layer 001 or the second conductive layer 002, and is substantially lost on the first conductive layer 001 under the action of the first conductive layer 001 and the second conductive layer 002. It can be learned that when the composite shielding film includes a plurality of second conductive layers 002, the grounding frame 02 and the composite shielding film can shield electromagnetic wave signals emitted by a plurality of electromagnetic wave signal sources 03 that are in one-to-one correspondence with the plurality of second conductive layers 002.

It may be understood that each of the plurality of electromagnetic wave signal sources 03 may be one or more components that can emit an electromagnetic wave signal. These components may be integrated, or may be distributed independently of each other. These components may be connected to each other, or may not be connected to each other. This is not limited in embodiments of this application.

Further, the grounding frame 02 in this embodiment of this application may be a closed frame, or may not be a closed frame. For example, when the grounding frame 02 is non-closed, the grounding frame 02 has at least one opening that communicates the target region M with the outside of the grounding frame 02 in an extension direction (parallel to the substrate 01) of the substrate 01.

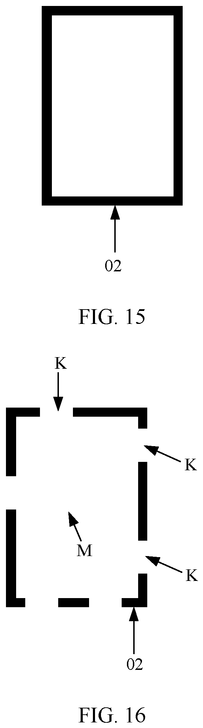

For example, assuming that a closed grounding frame 02 is shown in FIG. 15, a structure of a non-closed grounding frame 02 may be shown in FIG. 16, and the grounding frame 02 has a plurality of openings K that communicate the target region M with the outside of the grounding frame 02 in the extension direction (a direction parallel to a plane of paper in FIG. 16) of the substrate 01.

When the grounding frame 02 has the opening, a region in which the opening is located on the target surface of the substrate 01 may be used to arrange a structure (for example, a chip or a circuit) other than the grounding frame 02, so that a usable area of the target surface of the substrate 01 is increased. In addition, although the grounding frame 02 has the opening, under the action of the composite shielding film, the electromagnetic wave signal not shielded at the grounding frame 02 is substantially transmitted to the first conductive layer 001 and/or the second conductive layer 002 in the composite shielding film, and is not largely transmitted from the opening to the outside of the electromagnetic shielding structure. It can be learned that the opening of the grounding frame 02 does not greatly affect an electromagnetic shielding function of the electromagnetic shielding structure. If a shielding can is made of a nickel silver material in a related technology, when the grounding frame 02 has the opening, a large quantity of electromagnetic wave signals are transmitted from the opening to the outside of the electromagnetic shielding structure, and therefore, the electromagnetic shielding function of the electromagnetic shielding structure cannot be implemented.

Optionally, a ratio of a sum of areas of orthographic projection regions, on the reference plane, of regions in which all openings of the grounding frame 02 are located to a sum of areas of orthographic projection regions, on the reference plane, of regions in which parts other than the openings in the grounding frame 02 are located may be 2/3, 1/4, 3/2, or the like. It can be learned that an opening area of the grounding frame having an opening is 40%, 20%, 60%, or the like of a total area of the closed grounding frame. A size of the opening area is not limited in embodiments of this application.

It can be learned from the foregoing content that the electromagnetic shielding structure provided in embodiments of this application may be implemented in a plurality of manners. For example, the following provides examples of six electromagnetic shielding structures.

Example 1: A composite shielding film includes a first conductive layer, one or more second conductive layers, a conductive structure, a first insulation layer, and a second insulation layer. An electrical conductivity of the first conductive layer is 2000 S/m, and a thickness of the first conductive layer is 1 micrometer. An electrical conductivity of the second conductive layer is 1000 S/m, and a thickness of the second conductive layer is 10 micrometers. The conductive structure is connected to the first conductive layer and the second conductive layer, and the conductive structure is connected to a grounding frame, to ground the first conductive layer and the second conductive layer. The second conductive layer is located on a side that is of the first conductive layer and that is close to a substrate. A ratio of a sum of areas of orthographic projection regions, on a reference plane, of regions in which all openings of the grounding frame are located to a sum of areas of orthographic projection regions, on the reference plane, of regions in which parts other than the openings in the grounding frame are located is 2/3.

Example 2: On the basis of Example 1, the electrical conductivity of the first conductive layer changes to 2000 S/m, and the thickness of the first conductive layer changes to 10 micrometers. In addition, for an electromagnetic wave signal of 300 megahertz to 10 gigahertz, relative complex permeabilities/a relative complex permeability of the first conductive layer and the second conductive layer are/is 1.

Example 3: On the basis of Example 1, the electrical conductivity of the first conductive layer changes to 10000 S/m, the thickness of the first conductive layer changes to 50 micrometers, the electrical conductivity of the second conductive layer changes to 1x10⁶ S/m, and the thickness of the second conductive layer changes to 40 micrometers.

Example 4: On the basis of Example 1, the electrical conductivity of the first conductive layer changes to 80000 S/m, the thickness of the first conductive layer changes to 100 micrometers, the electrical conductivity of the second conductive layer changes to 4x10⁶ S/m, and the thickness of the second conductive layer changes to 100 micrometers.

Example 5: On the basis of Example 1, the electrical conductivity of the first conductive layer changes to 20000 S/m, and the thickness of the first conductive layer changes to 40 micrometers. The electrical conductivity of the second conductive layer changes to 3x10⁶ S/m, and the thickness of the second conductive layer changes to 50 micrometers. In addition, for an electromagnetic wave signal of 300 megahertz to 10 gigahertz, relative complex permeabilities/a relative complex permeability of the first conductive layer and the second conductive layer are/is 10.

Example 6: On the basis of Example 1, the electrical conductivity of the first conductive layer changes to 20000 S/m, and the thickness of the first conductive layer changes to 40 micrometers. The electrical conductivity of the second conductive layer changes to 3x10⁶ S/m, and the thickness of the second conductive layer changes to 50 micrometers. For an electromagnetic wave signal of 300 megahertz to 10 gigahertz, relative complex permeabilities/a relative complex permeability of the first conductive layer and the second conductive layer are/is 10. In addition, the grounding frame is a closed frame, and the grounding frame does not have an opening.

Test results shown in Table 1 may be obtained by performing a test for the six examples. In the test process, a global positioning system (global positioning system, GPS) module and a wireless (Wi-Fi) module are used as examples of an electromagnetic wave signal source to test strength of interference of the electromagnetic wave signal source to an antenna. The strength of interference can reflect an electromagnetic shielding effect. If the strength of interference is higher, it indicates that more electromagnetic wave signals are leaked, and the electromagnetic shielding effect is poorer. If the strength of interference is lower, it indicates that fewer electromagnetic wave signals are leaked, and the electromagnetic shielding effect is better.

**Table 1**

| Examples | Does the grounding frame have an opening | Strength of interference of the GPS module to antenna performance (unit: decibel (dB)) | Strength of interference of the Wi-Fi module to the antenna performance (unit: decibel (dB)) | Signal test conclusion (the test is passed if the strength of interference is less than or equal to 0.3) | Weight reduction gain (unit: weight percentage (wt%)) | Area gain (unit: percentage (%)) |
|---|---|---|---|---|---|---|
| 1 | Yes | 0.13 | 0.21 | Pass | 71 | 40 |
| 2 | Yes | 0.08 | 0.07 | Pass | 69 | 40 |
| 3 | Yes | 0.09 | 0.10 | Pass | 73 | 40 |
| 4 | Yes | 0.23 | 0.21 | Pass | 72 | 40 |
| 5 | Yes | 0.03 | 0.02 | Pass | 75 | 40 |
| 6 | No | 0.02 | 0.02 | Pass | 68 | 0 |

It can be learned from Table 1 that the test results of the electromagnetic shielding structures in the six examples are all relatively good, and signal test conclusions of the six examples are all "pass", indicating that electromagnetic shielding effects of the electromagnetic shielding structures provided in the six examples are all relatively good.

In addition, weights of the electromagnetic shielding structures provided in the six examples are all relatively small. Compared with an electromagnetic shielding structure that is of a nickel silver material with a thickness of 150 micrometers and that is used by a shielding can in a related technology, the electromagnetic shielding structures in the six examples all have reduced weights. A reduction proportion of a weight of an electromagnetic shield structure provided in each example compared with a weight of the electromagnetic shield structure that is of the nickel silver material with the thickness of 150 micrometers and that is used by the shielding can is represented as the weight reduction gain in Table 1. In other words, the weight reduction gain = (the weight of the electromagnetic shielding structure that is of the nickel silver material with the thickness of 150 micrometers and that is used by the shielding can - the weight of the electromagnetic shielding structure provided in the example)/the weight of the electromagnetic shielding structure that is of the nickel silver material with the thickness of 150 micrometers and that is used by the shielding can.

In addition, the grounding frame has an opening in Examples 1 to 5, and the grounding frame does not have an opening in Example 6. Therefore, a usable area on the substrate in Examples 1 to 5 is increased compared with that in Example 6, and it may be considered that Examples 1 to 5 each have an area gain (40%). However, Example 6 does not have an area gain, and the area gain is 0. In addition, it can be learned from Examples 1 to 6 that whether the grounding frame has an opening does not affect the electromagnetic shielding effect of the electromagnetic shielding structure.

Further, embodiments of this application further provide the following eight comparative examples for comparison with the foregoing six examples.

Comparative example 1: A shielding can uses an electromagnetic shielding structure of a nickel silver material with a thickness of 150 micrometers, the shielding can is connected to a grounding frame, and the grounding frame does not have an opening.

Comparative example 2: On the basis of Example 1, the conductive structure does not ground the first conductive layer or the second conductive layer.

Comparative example 3: A shielding can uses an electromagnetic shielding structure of a nickel silver material with a thickness of 100 micrometers, the shielding can is connected to a grounding frame, and the grounding frame has an opening.

Comparative example 4: A shielding can uses a carbon-based film with a thickness of 100 micrometers and an electrical conductivity of 10000 S/m as the shielding can, the shielding can is connected to a grounding frame, and the grounding frame has an opening.

Comparative example 5: A shielding can uses a carbon-based film with a thickness of 100 micrometers and an electrical conductivity of 20000 S/m as the shielding can, the shielding can is connected to a grounding frame, and the grounding frame has an opening.

Comparative example 6: On the basis of Example 1, the electrical conductivity of the first conductive layer changes to 500 S/m. It can be learned that the electrical conductivity of the first conductive layer does not range from 2000 S/m to 80000 S/m.

Comparative example 7: On the basis of Example 1, the electrical conductivity of the first conductive layer changes to 100000 S/m. It can be learned that the electrical conductivity of the first conductive layer does not range from 2000 S/m to 80000 S/m.

Comparative example 8: On the basis of Example 1, the electrical conductivity of the first conductive layer changes to 10000 S/m, and the electrical conductivity of the second conductive layer changes to 500 S/m. It can be learned that the electrical conductivity of the second conductive layer is not greater than or equal to 1000 S/m.

Test results shown in Table 2 may be obtained by performing a test for the eight comparative examples. In the test process, a GPS module and a Wi-Fi module are used as examples of an electromagnetic wave signal source to test strength of interference of the electromagnetic wave signal source to an antenna.

**Table 2**

| Comparative examples | Does the grounding frame have an opening | Strength of interference of the GPS module to antenna performance (unit: dB) | Strength of interference of the Wi-Fi module to the antenna performance (unit: dB) | Signal test conclusion (the test is passed if the strength of interference is less than or equal to 0.3) | Weight reduction gain (unit: wt%) | Area gain (unit: %) |
|---|---|---|---|---|---|---|
| 1 | No | 0.20 | 0.12 | Pass | 0 | 0 |
| 2 | Yes | 0.53 | 0.12 | Fail | / | / |
| 3 | Yes | 0.68 | 0.55 | Fail | / | / |
| 4 | Yes | 0.43 | 0.46 | Fail | / | / |
| 5 | Yes | 0.45 | 0.32 | Fail | / | / |
| 6 | Yes | 0.37 | 0.34 | Fail | / | / |
| 7 | Yes | 0.63 | 0.57 | Fail | / | / |
| 8 | Yes | 0.35 | 0.39 | Fail | / | / |

It can be learned from Table 2 that in the foregoing eight comparative examples, only a signal test conclusion of Comparative example 1 is "pass", and signal test conclusions of Comparative examples 2 to 8 are all "fail", indicating that electromagnetic shielding effects of electromagnetic shielding structures provided in Comparative examples 2 to 8 are all poor. Although the signal test result of Comparative example 1 is "pass", no weight reduction gain and area gain exist.

With reference to Examples 1 to 5 and Comparative example 2, it can be learned that grounding both the first conductive layer and the second conductive layer by the conductive structure plays a significant role. In Examples 1 to 5, the conductive structure grounds both the first conductive layer and the second conductive layer, so that an electromagnetic wave signal can be effectively conducted to a region between the first conductive layer and the second conductive layer, thereby helping the electromagnetic wave signal enter the first conductive layer to undergo loss, and the signal test is passed. Because in Comparative example 2, the conductive structure does not ground the first conductive layer or the second conductive layer, an electromagnetic wave signal cannot be effectively conducted to a region between the first conductive layer and the second conductive layer, and therefore, the electromagnetic wave signal cannot enter the first conductive layer to undergo loss, and the signal test is failed.

With reference to Examples 1 to 5 and Comparative examples 3 to 5, it can be learned that when the shielding can uses the composite shielding film provided in embodiments of this application, even if the grounding frame has an opening, the electromagnetic wave signal is not prone to leak from the opening, and therefore, the signal test is passed. When the shielding can uses a single material, if the grounding frame has an opening, the electromagnetic wave signal is prone to leak from the opening, and therefore, the signal test is failed.

With reference to Examples 1 to 5 and Comparative examples 6 to 8, it can be learned that, when the electrical conductivity of the first conductive layer falls within a range from 2000 S/m to 80000 S/m, and the electrical conductivity of the second conductive layer is greater than or equal to 1000 S/m, effective shielding can be implemented; and when the electrical conductivity of the first conductive layer falls outside the range from 2000 S/m to 80000 S/m, or the electrical conductivity of the second conductive layer is less than 1000 S/m, effective shielding cannot be implemented. In Comparative example 6, the electrical conductivity of the first conductive layer is less than 2000 S/m. In this case, the first conductive layer cannot effectively attenuate an electromagnetic wave signal that has been converged to a region between the first conductive layer and the second conductive layer, causing leakage of the electromagnetic wave signal. In Comparative example 7, the electrical conductivity of the first conductive layer is greater than 80000 S/m. In this case, a signal that has been converged to a region between the first conductive layer and the second conductive layer is reflected by the first conductive layer out of the electromagnetic shielding structure, causing leakage of the electromagnetic wave signal. In Comparative example 8, the electrical conductivity of the second conductive layer is less than 1000 S/m. The second conductive layer cannot effectively reflect an electromagnetic wave signal, and therefore, the electromagnetic wave signal cannot be converged to a region between the first conductive layer and the second conductive layer, causing leakage of the electromagnetic signal.

It should be noted that in the accompanying drawings, for clarity of illustration, sizes of some or all of structures may be exaggerated, and sizes, size relationships, proportions, shapes, and the like of these structures shown in the figures may be adjusted based on a requirement. For example, the grounding frame shown in FIG. 15 is in a shape of a regular rectangular frame. In some cases, the grounding frame may alternatively be in a shape of an irregular frame. For another example, the central region in FIG. 2, FIG. 3, and FIG. 5 is shaped in a rectangle. In some cases, alternatively, the central region may not be shaped in a rectangle, but may be shaped in an irregular shape. Correspondingly, an edge region surrounding the central region may also be in an irregular shape.

In this application, the terms "first", "second", and the like are merely intended for description, but cannot be understood as an indication or implication of relative importance. The term "at least one" means one or more, and the term "a plurality of" means two or more, unless expressly limited otherwise. The term "and/or" in this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In this application, "greater than" may be replaced with "greater than or equal to", and "less than" may be replaced with "less than or equal to". Correspondingly, "greater than or equal to" may be replaced with "greater than", and "less than or equal to" may be replaced with "less than".

In corresponding embodiments provided in this application, it should be understood that the disclosed structure may be implemented in other composition manners. For example, embodiments described above are merely examples.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A composite shielding film, comprising a first conductive layer, a second conductive layer, and a conductive structure, wherein
the first conductive layer and the second conductive layer are opposite to each other and spaced apart from each other, an orthographic projection region of the second conductive layer on a reference plane parallel to the first conductive layer is located in an orthographic projection region of the first conductive layer on the reference plane, an electrical conductivity of the first conductive layer ranges from 2000 siemens per meter to 80000 siemens per meter, and an electrical conductivity of the second conductive layer is greater than or equal to 1000 siemens per meter; and
the conductive structure is connected to the first conductive layer and the second conductive layer, and is configured to ground the first conductive layer and the second conductive layer.

2. The composite shielding film according to claim 1, wherein the electrical conductivity of the first conductive layer ranges from 20000 siemens per meter to 80000 siemens per meter, or ranges from 30000 siemens per meter to 50000 siemens per meter.

3. The composite shielding film according to claim 1 or 2, wherein the electrical conductivity of the second conductive layer is greater than the electrical conductivity of the first conductive layer.

4. The composite shielding film according to claim 3, wherein the electrical conductivity of the second conductive layer is greater than 100000 siemens per meter, or the electrical conductivity of the second conductive layer is greater than 500000 siemens per meter, or the electrical conductivity of the second conductive layer is greater than 1000000 siemens per meter.

5. The composite shielding film according to any one of claims 1 to 4, wherein the conductive structure comprises a first conductor and a second conductor;
the first conductor is located between the first conductive layer and the second conductive layer, and is connected to the first conductive layer and the second conductive layer; and
the second conductor is located on a side that is of the second conductive layer and that is away from the first conductive layer, and is connected to the second conductive layer, and the second conductor is configured to be grounded.

6. The composite shielding film according to claim 5, wherein the conductive structure further comprises a third conductor;
the third conductor is located on a side that is of the first conductive layer and that is close to the second conductive layer, and an orthographic projection region of the third conductor on the reference plane is located outside the orthographic projection region of the second conductive layer on the reference plane; and
the third conductor is connected to the first conductive layer, and the third conductor is configured to be grounded.

7. The composite shielding film according to any one of claims 1 to 6, wherein a material of the conductive structure comprises a conductive adhesive.

8. The composite shielding film according to any one of claims 1 to 7, wherein for an electromagnetic wave signal of 300 megahertz to 10 gigahertz, relative complex permeabilities of the first conductive layer and/or the second conductive layer are greater than or equal to 1.

9. The composite shielding film according to any one of claims 1 to 8, wherein thickness ranges/a thickness range of the first conductive layer and/or the second conductive layer are/is 1 micrometer to 100 micrometers.

10. The composite shielding film according to any one of claims 1 to 9, wherein a thermal conductivity of the first conductive layer ranges from 1 watt per meter per kelvin to 400 watts per meter per kelvin, and/or a thermal conductivity of the second conductive layer is greater than or equal to 10 watts per meter per kelvin.

11. The composite shielding film according to any one of claims 1 to 10, wherein the composite shielding film comprises a plurality of second conductive layers; and
the plurality of second conductive layers are spaced apart from each other on the plane parallel to the first conductive layer.

12. The composite shielding film according to any one of claims 1 to 11, wherein the composite shielding film further comprises a first insulation layer and/or a second insulation layer;
the first insulation layer is located between the first conductive layer and the second conductive layer; and
the second insulation layer is located on the side that is of the second conductive layer and that is away from the first conductive layer.

13. An electromagnetic shielding structure, comprising a substrate, a grounding frame, an electromagnetic wave signal source, and the composite shielding film according to any one of claims 1 to 12, wherein
the grounding frame is grounded, and the grounding frame is located on a target surface of the substrate, and surrounds a target region of the target surface;
the composite shielding film is located on a side that is of the grounding frame and that is away from the substrate, and a conductive structure in the composite shielding film is connected to the side that is of the grounding frame and that is away from the substrate; a second conductive layer in the composite shielding film is located between a first conductive layer and the grounding frame; and an orthographic projection region of the target region on a reference plane is located in an orthographic projection region of the second conductive layer on the reference plane; and
the electromagnetic wave signal source is located between the substrate and the composite shielding film, is located in the target region, and is insulated from both the grounding frame and the composite shielding film.

14. The electromagnetic shielding structure according to claim 13, wherein the composite shielding film comprises a plurality of second conductive layers, a plurality of target regions exist on the target surface, and the electromagnetic shielding structure comprises a plurality of electromagnetic wave signal sources;
the plurality of target regions are in one-to-one correspondence with the plurality of second conductive layers, and the orthographic projection region of the target region on the reference plane is located in an orthographic projection region of a corresponding second conductive layer on the reference plane; and
the plurality of target regions are in one-to-one correspondence with the plurality of electromagnetic wave signal sources, and the electromagnetic wave signal sources are located in the corresponding target regions.

15. The electromagnetic shielding structure according to claim 13 or 14, wherein the grounding frame has at least one opening that communicates the target region with the outside of the grounding frame in an extension direction of the substrate.

16. An electronic device, comprising the electromagnetic shielding structure according to any one of claims 13 to 15.

17. The electronic device according to claim 16, wherein the electronic device is a terminal device.
